Europäisches Patentamt

European Patent Office

Office européen des brevets

(11) Publication number: **0 146 323**
**A2**

(12)

# EUROPEAN PATENT APPLICATION

(21) Application number: **84308552.3**

(22) Date of filing: **07.12.84**

(51) Int. Cl.⁴: **C 23 C 14/34**, H 01 F 41/18
// G11B5/84

(30) Priority: **12.12.83 JP 234089/83**
**10.02.84 JP 23883/84**

(43) Date of publication of application: **26.06.85**
**Bulletin 85/26**

(84) Designated Contracting States: **DE FR GB**

(71) Applicant: **SONY CORPORATION,**
**7-35 Kitashinagawa 6-Chome Shinagawa-ku,**
**Tokyo 141 (JP)**

(72) Inventor: **Sato, Noboru c/o Patent Division Sony**
**Corporation, 7-35 Kitashinagawa-6, Shinagawa-ku Tokyo**
**(JP)**

(74) Representative: **Thomas, Christopher Hugo et al, D**
**Young & Co 10 Staple Inn, London WC1V 7RD (GB)**

(54) **Methods of making magnetic recording media(111111I).**

(57) A method of making a magnetic recording medium includes sputtering a magnetic material containing iron onto a substrate (3) in an atmosphere of argon gas mixed with nitrogen gas to deposit a magnetic film on the substrate (3). The nitrogen is preferably present in an amount of 10 to 10000 ppm, and a preferred version of the method comprises jointly sputtering a rare earth metal and an iron-cobalt alloy.

1

## METHODS OF MAKING MAGNETIC RECORDING MEDIA

This invention relates to methods of making magnetic recording media and to magnetic recording media so made. Embodiments of the magnetic recording media contain iron and include, for example, a magnetic medium comprising a composite Tb-FeCo magnetic film or a magnetic film of Fe-Co amorphous alloy which may be used, for example, as an optomagnetic recording medium, for example, an optomagnetic disc, capable of recording and reproducing by optical irradiation. The invention is also applicable to other magnetic media such as the usual magnetic recording media capable of recording and reproducing with a magnetic head by electromagnetic induction.

There has been previously proposed a composite amorphous alloy composed of rare earth metals such as Tb and Gd, and transition metals such as Fe and Co, for an optomagnetic disc capable of writing and reading by a laser beam, such as a semiconductor laser beam, and also capable of being rewritten.

Generally, vacuum evaporation is used for forming the magnetic film for this type of magnetic medium. Specifically, an evaporation source is heated by resistance heating, or an electron beam or ion beam is impacted on the evaporation source, or a sputtering method is used.

It is also known that the saturated intensity of magnetization Ms of a magnetic material is increased if nitrogen atoms are coupled with the iron, as compared with the case where the magnetic material contains iron only.

In a magnetic medium such as an optomagnetic recording medium, a minimum diameter (d) of its recording bit is given by the equation $d \propto Ew/(Ms.Hc)$, wherein Ms is the saturated intensity of magnetization; Hc is the coercive force; and Ew is the magnetic wall energy. According to the equation, when the saturated intensity of magnetization Ms is increased, it is evident that the diameter (d) of an information bit may be reduced, and accordingly high density of the magnetic material may be attained. Therefore, it is desirable that the saturated intensity of magnetization Ms of the magnetic medium be as large as possible.

On the other hand, it is known that the saturated intensity of magnetization Ms is increased in the case that nitrogen atoms are coupled with iron as the magnetic material, as compared with the case where the magnetic material contains iron alone. Accordingly, it is known that various magnetic media such as optomagnetic recording media can consist of a magnetic film containing iron coupled with nitrogen atoms.

According to the present invention there is provided a method of making a magnetic recording medium;

characterised by:

sputting a magnetic material containing iron onto a substrate in an atmosphere of argon gas mixed with nitrogen gas to form a magnetic film on said substrate.

In a preferred method according to the invention a composite Tb-FeCo magnetic film containing Fe and 5 to 30 atomic %, preferably 5 to 10 atomic % of cobalt or a FeCo magnetic material containing Fe and 5 to 50 atomic % of Co is sputtered onto a disc-like or film-like substrate in an atmosphere of argon at a pressure of $10^{-2}$ to $10^{3}$ Torr while admixed with nitrogen at a concentration of 10 to 10000 ppm to form a magnetic film.

By carrying out the sputtering in an atmosphere of argon mixed with nitrogen, a magnetic film possessing improved stability and repeatability, and which is superior in magnetic characteristics, and in particular having an improved saturated intensity of magnetization Ms can be obtained.

There are several possible methods of forming the magnetic film, for example, a resistance heating method and an electron beam or ion impact method. In the case of the resistance heating method and the electron beam impact vacuum vaporization method, the operation is carried out under high vacuum of about $10^{-7}$ Torr. In the case of the ion beam impact method, the operation is carried out under vacuum of about $10^{-5}$ Torr. In contrast, a sputtering method is carried out under a reduced pressure of about $10^{-2}$ to $10^{-3}$ Torr and therefore the particles to be sputtered may be effectively coupled with nitrogen atoms to improve the saturated intensity of magnetization Ms without excessively high vacuum conditions.

In the case where argon alone is used, the power of sputtering is increased. On the contrary, where nitrogen is mixed with argon, the power of sputtering may be reduced because the nitrogen is more active than the argon. Thus, mixing of nitrogen with argon is an advantage in itself. Additionally, the magnetic characteristics with respect to concentration of nitrogen are stable for alloys $Fe_{95-50}Co_{5-50}$, and accordingly the concentration of nitrogen may be selected from the wide range of 10 to 10000 ppm, which is also an advantage.

The invention will now be described by way of example with reference to the accompanying drawings, in which:

Figure 1 illustrates schematically a sputtering device for carrying out a method according to the present invention;

Figure 2 is a chart plotting intensity of magnetization Ms relative to concentration of nitrogen in a sputtering atmosphere; and

Figure 3 is a chart similar to Figure 2 illustrating a modified method.

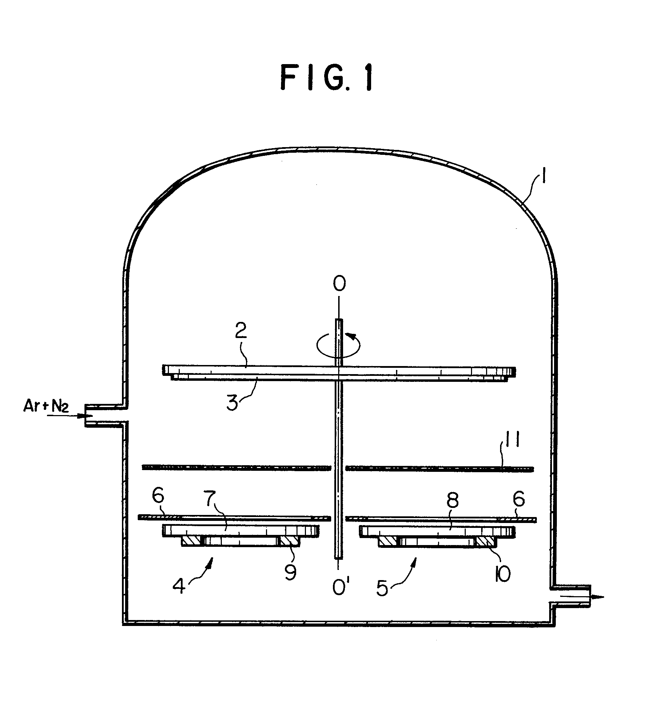

In Figure 1 there is shown a sputtering device including a bell jar 1 in which there is provided a base 2 rotatable about a centre axis O-O' of the jar 1. A substrate 3 of glass, acrylic resin or polycarbonate resin plate forms an objective magnetic medium, for example, an optomagnetic recording material, and is provided on a lower surface of the base 2. Two sputter sources 4 and 5 are arranged on opposite sides of the substrate 3 and spaced from each other at equal angles about the central axis O-O', that is to say, at an angle of $180^{o}$. A pair of masks 6 restrict the sputtering position of the metal to be sputtered from the sputter sources 4 and 5, and are positioned between the sputter sources 4 and 5 and the base 2 or the substrate 3. A shutter 11 is provided between the mask 6 and the substrate 3 so as to allow the material as sputtered on the substrate 3 to be stabilized in respect of its deposited condition. The sputter source 4 includes a target 7 formed of a rare earth metal, such as a Tb plate, and the sputter source 5 includes a target 8 formed of an FeCo alloy plate having the aforementioned desired composition, for example, an $Fe_{95-70}Co_{5-30}$ alloy plate containing 5 to 30 atomic % of cobalt. Magnets 9 and 10 are located below the targets 7 and 8.

After the air in the bell jar 1 has been exhausted, argon mixed with nitrogen is fed into the bell jar 1 and the substrate 3 is rotated with the gas mixture continuing to be introduced under a desired pressure. Then, the targets 7 and 8 are used as cathodes to carry out direct current sputtering. Specifically, the argon atmosphere in the bell jar 1 is adjusted in such a manner that air in the bell jar 1 is exhausted to a vacuum of about $5 \times 10^{-7}$ Torr, and then argon containing nitrogen in a concentration of 10 to 10000 ppm is fed into the bell jar 1 under a reduced pressure of about

$5 \times 10^{-3}$ Torr.

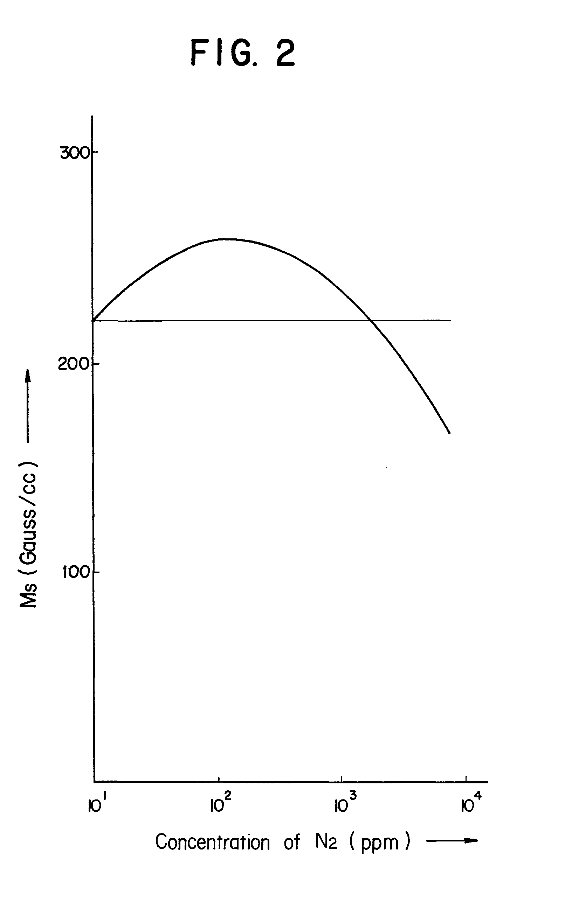

Figure 2 shows the results obtained in plotting the saturated intensity of magnetization Ms of a Tb-FeCo magnetic film obtained in the above manner relative to varying concentrations of nitrogen in admixture with the argon. As will be apparent from Figure 2, the saturated intensity of magnetization Ms is increased when the argon is mixed with nitrogen in a concentration of 10 to 1000 ppm as compared with the case when the sputtering is carried out in an atmosphere of argon only. In the case that the magnetic film is formed in an atmosphere of argon only, the saturated intensity of magnetization Ms is about 220 Gauss/cc, while in the case of formation in an atmosphere of argon containing nitrogen at 150 ppm, the saturated intensity of magnetization Ms is increased to about 260 Gauss/cc.

In a modified method, the sputter source 5 only can be used and the sputter source 4 with the target 7 omitted. In this case, the sputter source 5 includes a target 8 of FeCo alloy plate having the aforementioned composition, that is, an $Fe_{95-50}Co_{5-50}$ alloy plate containing 5 to 50 atomic % of cobalt.

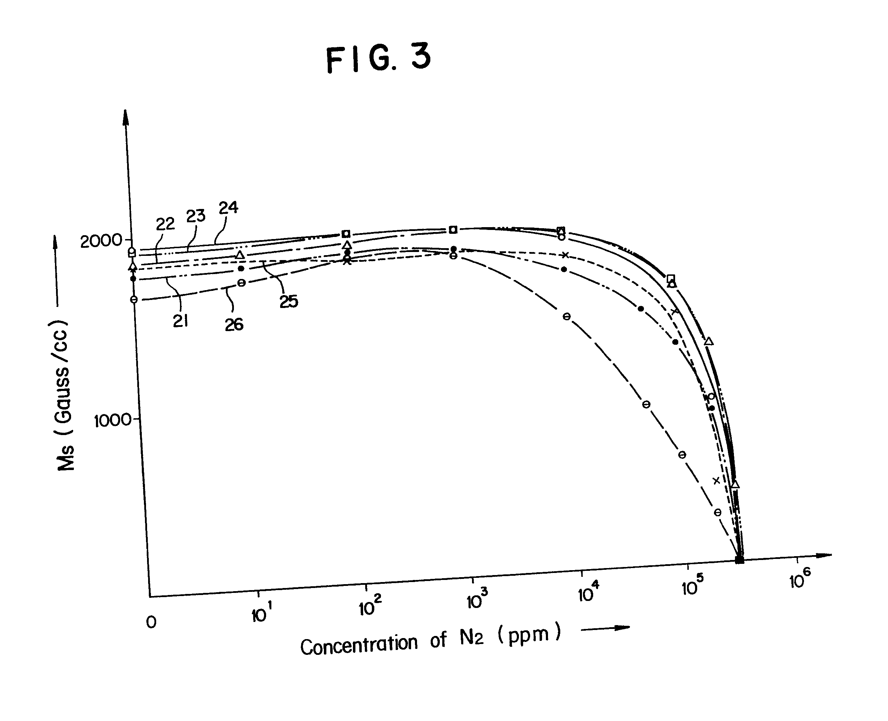

Figure 3 shows measurements obtained of saturated intensity of magnetization Ms relative to varying concentrations of nitrogen in the argon during sputtering similar to the above, but using iron only as the magnetic film. As will be apparent from the comparison of the curve 26 with the curves 21 to 25, the saturated intensity of magnetization Ms in the case of $Fe_{95-50}Co_{5-50}$ is greater than in the case of iron only and a high intensity of magnetization is obtained in stable form in a wide range of contents of nitrogen from 10 to 10000 ppm. This means that there is no criticality in the control of nitrogen in the argon and accordingly it is possible stably to obtain a magnetic medium having good repeatability and superior characteristics in practical production of a magnetic film, that is, production of a magnetic medium.

Although the above methods are applied to production of an optomagnetic recording media having a magnetic film, the present invention may also be applied to production of other types of magnetic media formed of composite materials containing iron.

## CLAIMS

1.    A method of making a magnetic recording medium; characterised by:
sputting a magnetic material containing iron onto a substrate in an atmosphere of argon gas mixed with nitrogen gas to form a magnetic film on said substrate.

2.    A method according to claim 1 wherein said nitrogen is present in an amount of 10 to 10000 ppm.

3.    A method according to claim 1 wherein a first source of sputtered metal in said atmosphere is a target of a rare earth metal.

4.    A method according to claim 3 wherein said sputtering takes place with a second source of sputtered metal including a target of FeCo alloy.

5.    A method according to claim 1 wherein said atmosphere of argon is at a pressure of $10^{-2}$ to $10^{-3}$ Torr.

6.    A method according to claim 4 wherein said FeCo alloy has the composition $Fe_{95-50}Co_{5-50}$.

7.    A method according to claim 4 wherein said FeCo alloy has the composition $Fe_{95-70}Co_{5-30}$.

8.    A method according to claim 3 wherein said rare earth is Tb.

9.    A magnetic recording medium made by a method according to any one of the preceding claims.

# FIG. 1

# FIG. 2

FIG. 3